# EUROPEAN PATENT APPLICATION

(11) **EP 4 579 006 A1**
(43) Date of publication of application: **02.07.2025**
(21) Application number: 22956419.0
(22) Date of filing: 22.08.2022
(51) Int. Cl.: C30B 29/36

(54) **SIC SUBSTRATE AND SIC COMPOSITE SUBSTRATE**

(71) Applicant: NGK Insulators, Ltd., Nagoya city, Aichi 467-8530 (JP)
(72) Inventor: URATA, Yuki, Nagoya-shi, Aichi 4678530 (JP); MATSUSHIMA, Kiyoshi, Nagoya-shi, Aichi 4678530 (JP); YOSHIKAWA, Jun, Nagoya-shi, Aichi 4678530 (JP)
(74) Representative: Müller-Boré & Partner Patentanwälte PartG mbB
(86) International application number: PCT/JP2022/031636
(87) International publication number: WO 2024/042591

(57) **Abstract**

There is provided a SiC substrate that can reduce breakings and cracks that occur during substrate processing such as grinding, polishing, and cutting. This SiC substrate includes a biaxially oriented SiC layer, and the SiC substrate and the biaxially oriented SiC layer have an off angle. With regard to this SiC substrate, in an XRT image obtained by subjecting a certain 4 mm-square region in the biaxially oriented SiC layer to X-ray topography (XRT) measurement, with respect to a total number of basal plane dislocations (BPD), a percentage of the number of BPDs such that an absolute value of an acute angle between a BPD extension direction and the [11-20] direction is 15° or less is 60% or more. The BPD extension direction is defined as a direction of a line segment connecting an end point of a BPD observed as a linear shape and a point 150 µm away from the end point along the linear BPD in the XRT image.

## Description

### TECHNICAL FIELD

The present invention relates to a SiC substrate and a SiC composite substrate.

### BACKGROUND ART

SiC (silicon carbide) has attracted attention as a wide bandgap material capable of controlling large voltage and large electric power with low loss. In recent years in particular, power semiconductor devices using SiC materials (SiC power devices) are superior to those using Si semiconductors in terms of downsizing, low power consumption, and high efficiency, and therefore are expected to be utilized in various applications. For example, by adopting the SiC power devices, a converter, an inverter, an in-vehicle charger, and the like for an electric vehicle (EV) or a plug-in hybrid vehicle (PHEV) can be downsized, making it possible to improve efficiency. Accordingly, development of a SiC wafer, which is the basis of the SiC power device, has attracted a lot of attention.

To produce a SiC power device, SiC single crystals need to be epitaxially grown on a SiC single crystal substrate. The obtained SiC single crystal substrate has a lot of dislocations, which are roughly classified into three types: a threading screw dislocation, a threading edge dislocation, and a basal plane dislocation (BPD). Among these dislocations, the basal plane dislocation is carried over to the epitaxial growth film, and if the basal plane dislocation is present in the drive region of the device, energization causes the basal plane dislocation to expand to a stacking defect, adversely affecting the reliability of the SiC device. Patent Literature 1 (JP2014-162649A) discloses a SiC substrate having a main surface inclined by an off angle from a plane perpendicular to the c-axis, wherein 80% or more of basal plane dislocations on the surface of the main surface are such that the angle between the dislocation line direction and the off direction of the off angle is 45° or more and 90° or less. It is stated that, where epitaxial growth is performed on the main surface of the SiC substrate, the basal plane dislocations on the surface of the main surface of the SiC substrate are not carried over to the epitaxial layer, whereby occurrence of basal plane dislocations of the epitaxial layer is suppressed. In addition, it is known that breakings and cracks occur when the SiC single crystal substrate is subjected to processing. Non-Patent Literature 1 (Y. Qiusheng, C. Senkai and P. Jisheng, "Surface and subsurface cracks characteristics of single crystal SiC wafer in surface machining," AIP Conference Proceedings 1653, 020091 (2015)) states that a single crystal SiC wafer was subjected to various processing for analysis of the characteristics of the cracks that occurred on the surface of the wafer in the processing.

### CITATION LIST

### PATENT LITERATURE

Patent Literature 1: JP2014-162649A

### NON-PATENT LITERATURE

Non-Patent Literature 1: Y. Qiusheng, C. Senkai and P. Jisheng, "Surface and subsurface cracks characteristics of single crystal SiC wafer in surface machining," AIP Conference Proceedings 1653, 020091 (2015)

### SUMMARY OF INVENTION

According to the disclosure of Non-Patent Literature 1, SiC is extremely hard and therefore is difficult to be processed. As such, there is a problem that the yield decreases due to breakings and cracks that occur during grinding, polishing, cutting, and the like of the wafer. The direct cause of the problem has not been clarified, but distortions in the crystal such as plastic deformations due to dislocations may be involved. That is, simply reducing the basal plane dislocations (BPD) in the substrate is insufficient, and reducing breakings and cracks that occur during substrate processing such as grinding, polishing, and cutting is desired.

The present inventors have now discovered that by allowing the SiC substrate to include a biaxially oriented SiC layer such that, in X-ray topography (XRT) measurement or optical microscope observation, the percentage of the number of BPDs such that the absolute value of an acute angle between a BPD extension direction and the [11-20] direction is 15° or less, with respect to the total number of BPDs, is controlled, it is possible to reduce breakings and cracks that occur during substrate processing such as grinding, polishing, and cutting.

Therefore, it is an object of the present invention to provide a SiC substrate that can reduce breakings and cracks that occur during substrate processing.

The present invention provides the following aspects:

### [Aspect 1]

A SiC substrate comprising a biaxially oriented SiC layer, wherein the SiC substrate and the biaxially oriented SiC layer have an off angle,
wherein, in an XRT image obtained by subjecting a certain 4 mm-square region in the biaxially oriented SiC layer to an X-ray topography (XRT) measurement, with respect to a total number of basal plane dislocations (BPD), a percentage of the number of the BPDs such that an absolute value of an acute angle between a BPD extension direction and the [11-20] direction is 15° or less is 60% or more, and
wherein the BPD extension direction is defined as a direction of a line segment connecting an end point of the BPD observed as a linear shape and a point 150 µm away from the end point along the linear BPD in the XRT image.

### [Aspect 2]

A SiC substrate comprising a biaxially oriented SiC layer, wherein the SiC substrate and the biaxially oriented SiC layer have an off angle,
wherein, in an optical microscope image obtained by observing a plane inclined by the off angle from a (0001) plane after a KOH etching in a certain 4 mm-square region in the biaxially oriented SiC layer, with respect to a total number of basal plane dislocations (BPD), a percentage of the number of the BPDs such that an absolute value of an acute angle between a BPD extension direction and the [11-20] direction is 15° or less is 70% or more, and
wherein the BPD extension direction is defined as the long axis direction of an oval etch pit identified in the optical microscope image.

### [Aspect 3]

The SiC substrate according to aspect 1 or 2, wherein a rare earth element concentration of the biaxially oriented SiC layer is 1.0 × 10¹⁴ to 5.0 × 10¹⁵ atoms/cm³.

### [Aspect 4]

The SiC substrate according to any one of aspects 1 to 3, wherein a N concentration of the biaxially oriented SiC layer is 1.0 × 10¹⁸ to 5.0 × 10¹⁹ atoms/cm³.

### [Aspect 5]

The SiC substrate according to any one of aspects 1 to 4, wherein a B concentration of the biaxially oriented SiC layer is 1.0 × 10¹⁵ to 1.0 × 10¹⁸ atoms/cm³.

### [Aspect 6]

The SiC substrate according to any one of aspects 1 to 5, wherein, in the optical microscope image obtained by observing the plane inclined by the off angle from the (0001) plane after the KOH etching in the biaxially oriented SiC layer, the SiC substrate includes a 5 mm-square region in which a density of the oval etch pit that is the BPD is 50/cm² or less.

### [Aspect 7]

A SiC composite substrate comprising:
a SiC single crystal substrate; and
the SiC substrate according to any one of aspects 1 to 6 on the SiC single crystal substrate.

### BRIEF DESCRIPTION OF DRAWINGS

Figure 1 is a longitudinal cross-sectional view of a SiC composite substrate 10.
Figure 2 is a diagram showing a process of manufacturing the SiC composite substrate 10.
Figure 3 is a conceptual diagram showing the configuration of an aerosol deposition (AD) apparatus 50.
Figure 4 is an X-ray topography (XRT) image of a biaxially oriented SiC layer in Example 1.
Figure 5 is an optical microscope image obtained by observing a plane inclined by an off angle from a (0001) plane of the biaxially oriented SiC layer in Example 1.

### DESCRIPTION OF EMBODIMENTS

### SiC Substrate

A SiC substrate according to the present invention is a SiC substrate comprising a biaxially oriented SiC layer, and they have an off angle. With regard to the biaxially oriented SiC layer, in an XRT image obtained by subjecting a certain 4 mm-square region in the biaxially oriented SiC layer to X-ray topography (XRT) measurement, with respect to the total number of basal plane dislocations (BPD), the percentage P_{BPD, XRT} (%) of the number of BPDs such that the absolute value of an acute angle between a BPD extension direction and the [11-20] direction is 15° or less is 60% or more. The BPD extension direction is defined as a direction of a line segment connecting the end point of a BPD observed as a linear shape and a point 150 µm away from the end point along the linear BPD in the XRT image. Alternatively, with regard to the biaxially oriented SiC layer, in an optical microscope image obtained by observing a plane inclined by an off angle from a (0001) plane after KOH etching in a certain 4 mm-square region in the biaxially oriented SiC layer, with respect to the total number of basal plane dislocations (BPD), the percentage P_{BPD, KOH} (%) of the number of BPDs such that the absolute value of an acute angle between a BPD extension direction and the [11-20] direction is 15° or less is 70% or more. The BPD extension direction is defined as the long axis direction of an oval etch pit identified in the optical microscope image. The certain 4 mm-square region refers to a region in the plate surface direction of the biaxially oriented SiC layer. The "4 mm-square region" is described as a region in which P_{BPD, XRT} or P_{BPD}, _{KOH}, is the above percentage, but herein, if P_{BPD, XRT} or P_{BPD}, _{KOH} in the "4 mm-square region" is the above percentage, it can be regarded that P_{BPD, XRT} or P_{BPD}, _{KOH} is the above percentage over the entire area of the biaxially oriented SiC layer. As described above, by allowing the SiC substrate to include a biaxially oriented SiC layer such that, in X-ray topography (XRT) measurement or optical microscope observation, the percentage of the number of BPDs such that the absolute value of an acute angle between a BPD extension direction and the [11-20] direction is 15° or less, with respect to the total number of BPDs, is controlled, it is possible to reduce breakings and cracks that occur during substrate processing such as grinding, polishing, and cutting.

As described above, SiC is extremely hard and therefore is difficult to be processed, and there is a problem that the yield decreases due to breakings and cracks that occur during grinding, polishing, cutting, and the like of the wafer. That is, simply reducing basal plane dislocations (BPD) in the substrate is insufficient, and reducing breakings and cracks that occur during substrate processing such as grinding, polishing, and cutting is desired. In this respect, according to the present invention, the problem is conveniently solved.

With regard to the biaxially oriented SiC layer that the SiC substrate of the present invention comprises, in an XRT image obtained by subjecting a certain 4 mm-square region in the biaxially oriented SiC layer to XRT measurement, P_{BPD}, _{XRT} is 60% or more. This P_{BPD}, _{XRT} may be 70% or more, 80% or more, or 90% or more. The upper limit of P_{BPD, XRT} is not particularly limited, but is typically 100%. Alternatively, with regard to this biaxially oriented SiC layer, in an optical microscope image obtained by observing a plane inclined by an off angle from a (0001) plane after KOH etching in a certain 4 mm-square region in the biaxially oriented SiC layer, P_{BPD}, _{KOH} is 70% or more. This P_{BPD}, _{KOH} may be 80% or more, or 90% or more. The upper limit of P_{BPD}, _{KOH} is not particularly limited, but is typically 100%. If P_{BPD, XRT} or P_{BPD}, _{KOH} is such a percentage, breakings and cracks that occur during substrate processing can be reduced more effectively.

The biaxially oriented SiC layer that the SiC substrate of the present invention comprises preferably includes a 5 mm-square region in which, in an optical microscope image obtained by observing a plane inclined by an off angle from a (0001) plane after KOH etching in the biaxially oriented SiC layer, the density of an oval etch pit that is a BPD is 50/cm² or less. This BPD density may be 1 to 40/cm², or 1 to 10/cm². The 5 mm-square region refers to a region in the plate surface direction of the biaxially oriented SiC layer. The "5 mm-square region" is described as a region in which the BPD density is the above density, but herein, if the BPD density in the "5 mm-square region" is the above density, it can be regarded that the BPD density is the above density over the entire area of the biaxially oriented SiC layer. As described above, with regard to the SiC substrate of the present invention, it is possible to reduce breakings and cracks that occur during substrate processing such as grinding, polishing, and cutting, while reducing BPDs in the biaxially oriented SiC layer. Furthermore, it is considered that the number of BPDs present in the SiC substrate (specifically, the biaxially oriented SiC layer) having the above BPD density is small, most BPDs are such that the absolute values of acute angles between the BPD extension direction and the [11-20] direction are uniformly 15° or less, whereby distortions in the crystal are reduced in size. Thus, not only can the breakings and cracks that occur during substrate processing be reduced, but also the yield in production of the substrate can be improved.

The SiC substrate or the biaxially oriented SiC layer has an off angle, and the off angle is preferably 0.1 to 12°, and more preferably 1 to 5° from the [0001] axis of the SiC substrate or the biaxially oriented SiC layer.

Examples of the rare earth element contained in the biaxially oriented SiC layer include Y, La, Ce, Pr, Nd, Pm, Sm, Eu, Gd, Tb, Dy, Ho, Er, Tm, Yb, Lu, Sc, and combinations thereof. The rare earth element is preferably Y or Ce from the viewpoint of reducing breakings and cracks, and Y is more preferable.

The rare earth element concentration in the biaxially oriented SiC layer is preferably 1.0 × 10¹⁴ to 5.0 × 10¹⁵ atoms/cm³, more preferably 5.0 × 10¹⁴ to 5.0 × 10¹⁵ atoms/cm³, and further preferably 5.0 × 10¹⁴ to 1.4 × 10¹⁵ atoms/cm³ where Y is contained and 5.0 × 10¹⁴ to 4.0 × 10¹⁵ atoms/cm³ where Ce is contained. The N concentration of the biaxially oriented SiC layer is preferably 1.0 × 10¹⁸ to 5.0 × 10¹⁹ atoms/cm³, more preferably 1.0 × 10¹⁸ to 2.0 × 10¹⁹ atoms/cm³, and further preferably 1.0 × 10¹⁸ to 1.0 × 10¹⁹ atoms/cm³. The B concentration of the biaxially oriented SiC layer is preferably 1.0 × 10¹⁵ to 1.0 × 10¹⁸ atoms/cm³, and more preferably 2.0 × 10¹⁵ to 1.0 × 10¹⁷ atoms/cm³. If the rare earth element, N, or B concentration is within the above range, the BPD extension direction and the BPD density can effectively be controlled.

The biaxially oriented SiC layer is preferably oriented in the c-axis direction and the a-axis direction. In addition, the SiC substrate is preferably composed of the biaxially oriented SiC layer. The biaxially oriented SiC layer may be a SiC single crystal, a SiC polycrystal, or a mosaic crystal as long as the biaxially oriented SiC layer is oriented in the biaxial directions of the c-axis direction and the a-axis direction. The mosaic crystal refers to an aggregate of crystals not having clear grain boundaries but being such that the orientation directions of the crystals are slightly different from one or both of the c-axis and the a-axis. The method for evaluating the orientation is not particularly limited, but known analysis methods such as an EBSD (Electron Back Scatter Diffraction Patterns) method and an X-ray pole figure can be used. For example, when the EBSD method is used, inverse pole figure mapping of a surface (plate surface) of the biaxially oriented SiC layer or a section orthogonal to the plate surface is measured. When the following four conditions are satisfied in the resultant inverse pole figure mapping, the SiC layer can be defined as being biaxially oriented in an approximate normal direction and an approximate plate surface direction: (A) the SiC layer is oriented in a particular direction (the first axis) in an approximate normal direction of the plate surface; (B) the SiC layer is oriented in a particular direction (the second axis) in an approximate in-plate-surface direction, the direction orthogonal to the first axis; (C) tilt angles from the first axis are distributed within ±10°; and (D) tilt angles from the second axis are distributed within ±10°. In other words, when the four conditions are satisfied, the SiC layer is determined to be biaxially oriented along the c-axis and the a-axis. For example, when the approximate normal direction of the plate surface is oriented along the c-axis, the approximate in-plate-surface direction only needs to be oriented in a particular direction (for example, the a-axis) orthogonal to the c-axis. The biaxially oriented SiC layer only needs to be biaxially oriented in the approximate normal direction and the approximate in-plate-surface direction, but the approximate normal direction is preferably oriented along the c-axis direction. As a tilt angle distribution in the approximate normal direction and/or the approximate in-plate-surface direction is smaller, the mosaicity of the biaxially oriented SiC layer is smaller, and as the tilt angle distribution is closer to zero, the biaxially oriented SiC layer is closer to a single crystal. Therefore, in view of the crystallinity of the biaxially oriented SiC layer, the tilt angle distribution is preferably smaller in both the approximate normal direction and the approximate plate surface direction, more preferably, for example, ±5° or less, and further preferably ±3° or less.

### SiC Composite Substrate

The SiC substrate of the present invention is preferably in the form of a SiC composite substrate. That is, according to a preferable embodiment of the present invention, a SiC composite substrate comprising a SiC single crystal substrate and the above-described SiC substrate on the SiC single crystal substrate is provided. As described above, breakings and cracks that occur during substrate processing can be reduced if the SiC composite substrate comprises a SiC substrate comprising a biaxially oriented SiC layer such that, when the SiC substrate is subjected to X-ray topography (XRT) measurement or optical microscope observation, with respect to the total number of BPDs, the percentage of the number of BPDs is controlled such that the absolute value of an acute angle between the BPD extension direction and the [11-20] direction is 15° or less.

The SiC single crystal substrate is typically a layer composed of a SiC single crystal and has a crystal growth surface. The SiC single crystal substrate preferably has an off angle. The polytype, off angle, and polarity of the SiC single crystal are not particularly limited, but the polytype is preferably 4H or 6H, the off angle is preferably 0.1 to 12° from the [0001] axis of single crystal SiC, and the polarity is preferably the Si surface. More preferably, the polytype is 4H, the off angle is 1 to 5° from the [0001] axis of single crystal SiC, and the polarity is the Si surface.

The SiC substrate of the present invention may be in the form of a self-supporting substrate consisting of a biaxially oriented SiC layer or may be in the form of a SiC composite substrate with a SiC single crystal substrate. Therefore, the biaxially oriented SiC layer may be finally separated from the SiC single crystal substrate as necessary. The separation of the SiC single crystal substrate may be performed by a known method and is not particularly limited. Examples of the known method include a method of separating the biaxially oriented SiC layer with a wire saw, a method of separating the biaxially oriented SiC layer by electro discharge machining, and a method of separating the biaxially oriented SiC layer utilizing laser. In an embodiment in which the biaxially oriented SiC layer is epitaxially grown on a SiC single crystal substrate, the biaxially oriented SiC layer may be installed on another support substrate after the SiC single crystal substrate is separated. The material of the another support substrate is not particularly limited and suitable one may be selected in view of physical properties of the material. In view of thermal conductivity for example, examples of the material include metal substrates such as a Cu substrate and ceramic substrates such as a SiC substrate and an AIN substrate.

### Method for Manufacturing SiC Composite Substrate

The SiC composite substrate comprising the SiC substrate of the present invention can be preferably manufactured by (a) forming a predetermined orientation precursor layer on a SiC single crystal substrate, (b) subjecting the orientation precursor layer to heat treatment on the SiC single crystal substrate to convert at least a portion of the orientation precursor layer near the SiC single crystal substrate into a SiC substrate (biaxially oriented SiC layer), and, optionally, (c) performing processing such as grinding or polishing to expose the surface of the biaxially oriented SiC layer. However, the method for manufacturing the SiC composite substrate is not limited as long as a SiC substrate such that P_{BPD, XRT} or P_{BPD}, _{KOH} is controlled to a specific percentage can be obtained. For example, as the manufacturing method, vapor phase methods such as CVD and a sublimation method may be adopted, or liquid phase methods such as a solution method may be adopted. A rare earth element, B and/or N may be added by the method described later. In accordance with such production methods, a satisfactory SiC substrate comprising a biaxially oriented SiC layer such that P_{BPD, XRT} or P_{BPD, KOH} is controlled to a specific percentage can be produced, whereby breakings and cracks that occur during processing of the SiC substrate or a SiC composite substrate using the SiC substrate can effectively be reduced.

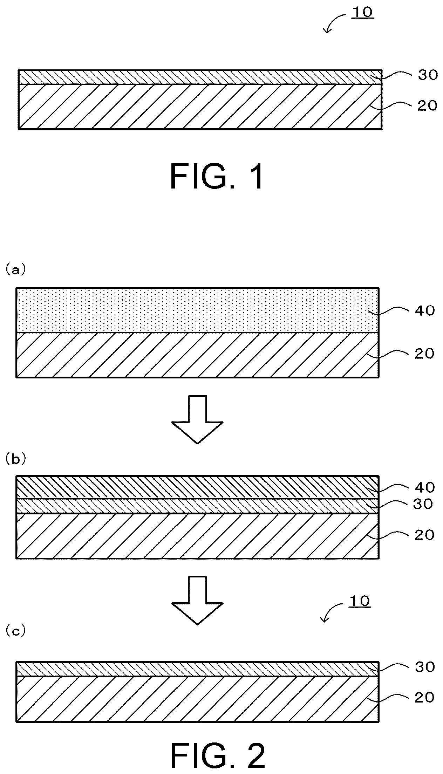

Hereinafter, a preferred method for manufacturing the SiC composite substrate will be described. Figure 1 is a longitudinal cross-sectional view of a SiC composite substrate 10 (a cross-sectional view obtained by cutting the SiC composite substrate 10 vertically along a plane including the central axis of the SiC composite substrate 10). Figure 2 is a diagram showing a process of manufacturing the SiC composite substrate 10.

As shown in Figure 1, the SiC composite substrate 10 of the present embodiment comprises: a SiC single crystal substrate 20; and a SiC substrate 30 (corresponding to the SiC substrate of the present invention) on the SiC single crystal substrate.

### (a) Process of Forming Orientation Precursor Layer

As shown in Figure 2(a), an orientation precursor layer 40 is made into the SiC substrate (biaxially oriented SiC layer) 30 by heat treatment, which will be described later. In the process of forming the orientation precursor layer 40, the orientation precursor layer 40 is formed on a crystal growth surface of the SiC single crystal substrate 20.

As the method for forming the orientation precursor layer 40, a known method can be adopted. Examples of the method for forming the orientation precursor layer 40 include solid phase film deposition methods such as an AD (Aerosol Deposition) method and a HPPD (Hypersonic Plasma Particle Deposition) method, vapor phase film deposition methods such as a sputtering method, a vapor deposition method, a sublimation method, and various CVD (Chemical Vapor Deposition) methods, and liquid phase film deposition methods such as a solution growth method, and a method of directly forming the orientation precursor layer 40 on the SiC single crystal substrate 20 can be used. As the CVD method, for example, a thermal CVD method, a plasma CVD method, a mist CVD method, and a MO (Metal Organic) CVD method can be used. Further, it is also possible to use a method in which a polycrystalline substance previously produced by a sublimation method, any of various CVD methods, sintering, or the like is used as the orientation precursor layer 40, and the polycrystalline substance is placed on the SiC single crystal substrate 20. Alternatively, the method for forming the orientation precursor layer 40 may also be a method in which a green body of the orientation precursor layer 40 is preliminarily produced, and this green body is placed on the SiC single crystal substrate 20. Such an orientation precursor layer 40 may be tape green body produced by tape casting or a green compact produced by pressure forming such as uniaxial pressing.

In forming these orientation precursor layers 40, a rare earth compound is preferably contained in the raw materials for the orientation precursor layers 40. Thus, the concentration of the rare earth compound in the biaxially oriented SiC layer can be controlled. Examples of the rare earth compound include, but are not particularly limited to, an oxide, a nitride, a carbide, and a fluoride of at least one element among the 17 rare earth elements described above. As the rare earth compound, an oxide of a rare earth element is preferable, and an oxide of Y (yttrium oxide) and an oxide of Ce (cerium oxide) are more preferable. Also, the concentration of B in the biaxially oriented SiC layer can be controlled by adjusting the amount of boron or a boron compound (for example, a boron carbide) to be added to the raw material, calcining the raw material, or vapor-depositing metallic boron on the SiC single crystal. Furthermore, the angle between the BPD extension direction and the [11-20] direction can effectively be controlled by a type of carrier gas (for example, He or N₂) used for forming the orientation precursor layer 40.

When any of various CVD methods, a sublimation method, a solution growth method, or the like is used in the method of directly forming the orientation precursor layer 40 on the SiC single crystal substrate 20, epitaxial growth may occur on the SiC single crystal substrate 20 without a heat treatment process, which will be described later, so that the SiC substrate 30 may be deposited. However, the orientation precursor layer 40 is preferably not oriented, specifically is preferably an amorphous or non-oriented polycrystal, at the time of formation, and is preferably oriented using a SiC single crystal as a seed in the heat treatment process in a later stage. Thus, crystal defects that reach the surface of the SiC substrate 30 can be effectively reduced. The reason for this is not certain, but it is considered that the solid phase orientation precursor layer once deposited causes rearrangement of the crystal structure using a SiC single crystal as a seed, and this may also have an effect in disappearance of crystal defects. Therefore, when any of various CVD methods, a sublimation method, a solution growth method, or the like is used, it is preferred to select conditions that do not cause epitaxial growth to occur in the process of forming the orientation precursor layer 40.

However, the method for forming the orientation precursor layer 40 is preferably a method of directly forming the orientation precursor layer 40 on the SiC single crystal substrate 20 by an AD method or any of various CVD methods, or a method of placing a polycrystalline substance on the SiC single crystal substrate 20, wherein the polycrystalline substance is separately produced by a sublimation method, any of various CVD methods, sintering, or the like. The use of these methods makes it possible to form the orientation precursor layer 40 in a relatively short time. The AD method is particularly preferred because a high-vacuum process is unnecessary, and the film deposition rate is relatively high. In the method using a previously produced polycrystalline substance as the orientation precursor layer 40, ingenuity such as making the surface of the polycrystalline substance sufficiently smooth in advance is necessary in order to enhance the adhesion between the polycrystalline substance and the SiC single crystal substrate 20. Therefore, the method of directly forming the orientation precursor layer 40 is preferred in view of cost. The method of placing a previously produced green body on the SiC single crystal substrate 20 is also preferred as a simple method, but the orientation precursor layer 40 is composed of a powder, and therefore a sintering process is necessary in the heat treatment process, which will be described later. Known conditions can be used in any of the methods, but hereinafter, description will be made on the method of directly forming the orientation precursor layer 40 on the SiC single crystal substrate 20 by an AD method or a thermal CVD method and the method of placing a previously produced green body on the SiC single crystal substrate 20.

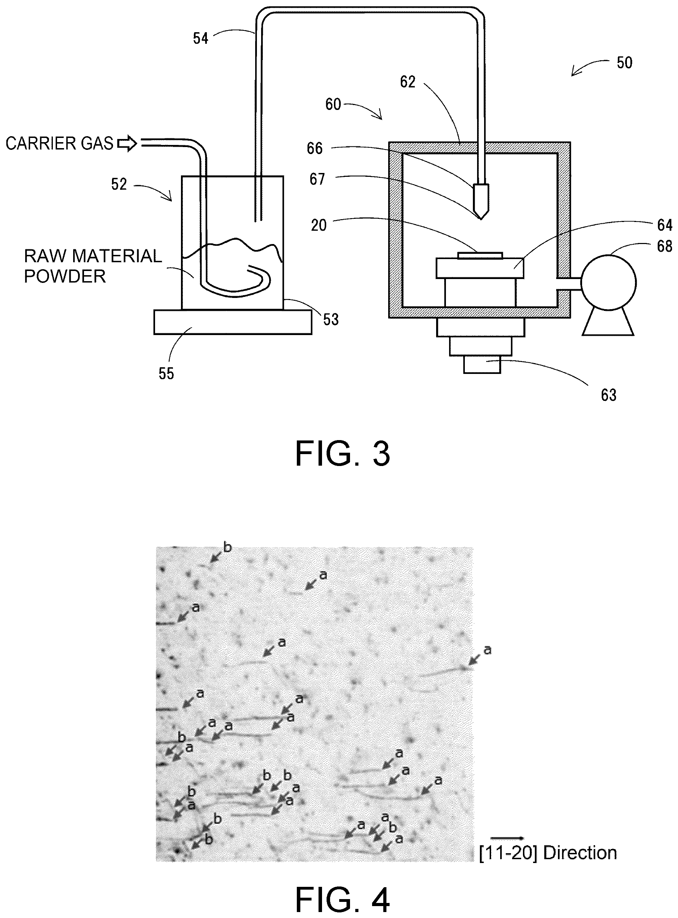

The AD method is a technique such that fine particles or fine particle raw materials are mixed with a gas to form aerosol, and this aerosol is jetted at a high speed from a nozzle to allow the aerosol to collide with a substrate to form a coat and has a characteristic that the coat can be formed at normal temperature. Figure 3 shows an example of a film deposition apparatus (AD apparatus) that is used in such an AD method. An AD apparatus 50 shown in Figure 3 is configured as an apparatus that is used in an AD method in which a raw material powder is jetted onto a substrate in an atmosphere where the air pressure is lower than the atmospheric pressure. This AD apparatus 50 comprises: an aerosol generation unit 52 that generates aerosol of a raw material powder containing raw material components; and a film deposition unit 60 that jets the raw material powder onto the SiC single crystal substrate 20 to form a film containing the raw material components. The aerosol generation unit 52 comprises: an aerosol generation chamber 53 that receives supply of a carrier gas from a gas cylinder that stores the raw material powder, the gas cylinder not shown, to generate aerosol; a raw material supply pipe 54 that supplies generated aerosol to the film deposition unit 60; and a vibration exciter 55 that gives vibration of a frequency of 10 to 100 Hz to the aerosol generation chamber 53 and the aerosol therein. The film deposition unit 60 comprises: a film deposition chamber 62 that jets the aerosol onto the SiC single crystal substrate 20; a substrate holder 64 that is fixedly set up inside the film deposition chamber 62 to fix the SiC single crystal substrate 20; and an X-Y stage 63 that moves the substrate holder 64 in the X-axis and Y-axis directions. Further, the film deposition unit 60 comprises: a jet nozzle 66 that has a slit 67 formed at the tip and jets the aerosol onto the SiC single crystal substrate 20; and a vacuum pump 68 that reduces the pressure in the film deposition chamber 62. The jet nozzle 66 is attached to the tip of the raw material supply pipe 54.

The AD method is known to generate pores in a film or make a film into a green compact depending on the film deposition conditions. For example, the AD method is susceptible to the collision speed of the raw material powder onto the substrate, the particle size of the raw material powder, the aggregation state of the raw material powder in the aerosol, the jetting amount per unit time, and the like. The collision speed of the raw material powder onto the substrate is influenced by the differential pressure between the inside of the film deposition chamber 62 and the inside of the jet nozzle 66, the opening area of the jet nozzle, and the like. Therefore, to obtain a dense orientation precursor layer, these factors need to be controlled properly.

In the thermal CVD method, known film deposition apparatuses such as commercially available film deposition apparatuses can be utilized as a film deposition apparatus. The raw material gas is not particularly limited, and a silicon tetrachloride (SiCl₄) gas and a silane (SiH₄) gas as a supply source of Si, and a methane (CH₄) gas, a propane (C₃H₈) gas, and the like as a supply source of C can be used. The film deposition temperature is preferably 1000 to 2200°C, more preferably 1100 to 2000°C, and further preferably 1200 to 1900°C.

When the film is deposited on the SiC single crystal substrate 20 using the thermal CVD method, it is known that epitaxial growth may occur on the SiC single crystal substrate 20 to form the SiC substrate 30. However, the orientation precursor layer 40 is preferably not oriented, specifically is preferably an amorphous or non-oriented polycrystal, at the time of production, and it is preferred to allow rearrangement of the crystals to occur using a SiC single crystal as a seed crystal during the heat treatment process. The film deposition temperature, the flow rates of gases such as a Si source and a C source and the ratio thereof, the film deposition pressure, and the like are known to give influences in forming an amorphous or polycrystal layer on a SiC single crystal using the thermal CVD method. The influence of the film deposition temperature is large, and in view of forming an amorphous or polycrystal layer, the film deposition temperature is preferably lower, preferably lower than 1700°C, more preferably 1500°C or lower, and further preferably 1400°C or lower. However, when the film deposition temperature is too low, the film deposition rate itself is also lowered, and therefore the film deposition temperature is preferably higher in view of the film deposition rate.

When a previously produced green body is used as the orientation precursor layer 40, the green body can be produced by forming a raw material powder for the orientation precursor. For example, when press forming is used, the orientation precursor layer 40 is a press-formed green body. The press-formed green body can be produced by subjecting the raw material powder for the orientation precursor to press forming based on a known method and may be produced by, for example, putting the raw material powder into a metal mold and pressing the raw material powder at a pressure of preferably 100 to 400 kgf/cm², and more preferably 150 to 300 kgf/cm². The forming method is not particularly limited, and tape casting, extrusion forming, slip casting, and a doctor blade method, and optional combinations thereof can be used in addition to press forming. For example, when tape casting is used, additives such as a binder, a plasticizer, a dispersant, and a dispersion medium are appropriately added to the raw material powder to make a slurry, and this slurry is preferably allowed to pass through a slit-like thin ejection port to be ejected and formed into a sheet. The thickness of the green body formed into a sheet is not limited but is preferably 5 to 500 µm in view of handling. When a thick orientation precursor layer is necessary, a plurality of the sheet green bodies may be stacked into a desired thickness for use. A portion of these green bodies near the SiC single crystal substrate 20 is made into the SiC substrate 30 by the subsequent heat treatment on the SiC single crystal substrate 20. In such a method, the green bodies need to be sintered in the heat treatment process, which will be described later. The SiC substrate 30 is preferably formed after the green bodies are subjected to the process in which the green bodies are sintered and integrated as a polycrystalline substance with the SiC single crystal substrate 20. When the green bodies do not undergo a sintered state, epitaxial growth using a SiC single crystal as a seed may occur insufficiently. Therefore, the green body may contain an additive such as a sintering aid in addition to the SiC raw material.

### (b) Heat Treatment Process

As shown in Figure 2(b), in the heat treatment process, a laminate in which the orientation precursor layers 40 are laminated or placed on the SiC single crystal substrate 20 are subjected to heat treatment to generate the SiC substrate 30. The heat treatment method is not particularly limited as long as epitaxial growth using the SiC single crystal substrate 20 as a seed occurs, and can be performed in a known heat treatment furnace such as a tube furnace or a hot plate. Not only heat treatment under normal pressure (pressless heat treatment) but also heat treatment under pressure such as hot pressing and HIP and a combination of the heat treatment under normal pressure and the heat treatment under pressure can be used. The atmosphere during the heat treatment can be selected from vacuum, nitrogen, and inert gas atmospheres, and combinations thereof. At this time, the concentration of N in the biaxially oriented SiC layer can be controlled by adjusting the amount of nitrogen in the atmosphere during the heat treatment. The heat treatment temperature is preferably 1700 to 2700°C. By increasing the temperature, the orientation precursor layer 40 is likely to grow using the SiC single crystal substrate 20 as a seed crystal while being oriented along the c-axis and the a-axis. Therefore, the heat treatment temperature is preferably 1700°C or higher, more preferably 1800°C or higher, further preferably 1900°C or higher, and particularly preferably 2200°C or higher. On the other hand, when the temperature is excessively high, there is a possibility that part of SiC is lost by sublimation or SiC is plastically deformed to cause a defect such as, for example, a warp. Therefore, the heat treatment temperature is preferably 2700°C or lower, and more preferably 2500°C or lower. However, the heat treatment conditions give an influence on the concentrations of the rare earth element, N, and B in the biaxially oriented SiC layer, and therefore it is preferred to appropriately control the conditions (for example, the heat treatment temperature and holding time). From such viewpoints, the heat treatment temperature is preferably 1900 to 2700°C, more preferably 2200 to 2600°C, and further preferably 2400 to 2500°C. The holding time is preferably 2 to 30 hours, and more preferably 4 to 20 hours. Also, the heat treatment may be performed in a plurality of steps. For example, the heat treatment may be performed under the condition in which heat treatment is performed in a nitrogen atmosphere at 1950°C for three hours, and then heat treatment is performed in an argon atmosphere at 2400°C for three hours. Even in such a case, the heat treatment temperature and the total holding time are preferably within the above ranges. Furthermore, the heat treatment temperature and the holding time have a relationship with the thickness of the SiC substrate 30 generated by epitaxial growth and can be appropriately adjusted.

However, a previously produced green body, when used as the orientation precursor layer 40, needs to be sintered during the heat treatment, and normal pressure firing at a high temperature, hot pressing, HIP, or a combination thereof is suitable. For example, when hot pressing is used, the surface pressure is preferably 50 kgf/cm² or higher, more preferably 100 kgf/cm² or higher, and further preferably 200 kgf/cm² or higher, and there is no upper limit in particular. In addition, the firing temperature is not particularly limited as long as sintering and epitaxial growth occur. However, the firing conditions give an influence on the concentrations of the rare earth element, N, and B in the biaxially oriented SiC layer, and therefore it is preferred to appropriately control the conditions (for example, the firing temperature and holding time). From such viewpoints, the firing temperature is preferably 1700 to 2700°C. The holding time is preferably 2 to 18 hours. The atmosphere during the firing can be selected from vacuum, nitrogen, and inert gas atmospheres, or a mixed gas of nitrogen and an inert gas. Also, similarly to what is described above, the firing may be performed in a plurality of steps, and the firing temperature and the total holding time are preferably within the above range. The SiC powder which is a raw material may be composed of at least one of an α-SiC powder and a β-SiC powder, but the SiC powder is preferably composed of a β-SiC powder. The SiC powder is preferably composed of SiC particles having an average particle size of 0.01 to 100 µm. The average particle size refers to an average value obtained when the powder is observed with a scanning electron microscope to measure the maximum sizes in a constant direction for 100 primary particles.

In the heat treatment process, the crystals in the orientation precursor layer 40 grow while being oriented along the c-axis and the a-axis from the crystal growth surface of the SiC single crystal substrate 20, and therefore the orientation precursor layer 40 is gradually changed into the SiC substrate 30 from the crystal growth surface. The SiC composite substrate comprising the generated SiC substrate 30 is such that breakings and cracks that occur during substrate processing are reduced.

### (c) Grinding and/or Polishing Process

As shown in Figure 2(c), in the grinding process, the orientation precursor layer 40 left on the SiC substrate 30 after the heat treatment process is ground away to expose the surface of the SiC substrate 30, and the exposed surface is subjected to grinding and/or polishing. Thus, the SiC composite substrate 10 is obtained.

The present invention is not limited to the above-described embodiments, and it is needless to say that that the present invention can be conducted in various aspects as long as they belong to the technical scope of the present invention. For example, in the above-described embodiment, only one layer of the SiC substrate 30 is provided on the SiC single crystal substrate 20, but two or more layers may be provided. Specifically, by stacking the orientation precursor layer 40 on the SiC substrate 30 of the SiC composite substrate 10, performing heat treatment, and then performing grinding and/or polishing in the mentioned order, the SiC substrate 30 as the second layer can be provided on the SiC substrate 30.

### EXAMPLES

The present invention will be more specifically described by the following examples.

### Example 1

### (1) Production of Orientation Precursor Layer

A raw material powder containing 90.8% by weight of a commercially available β-SiC fine powder (volume-based D50 particle size: 0.7 µm), 8.1% by weight of an yttrium oxide powder (volume-based D50 particle size: 0.1 µm), and 1.1% by weight of a silicon dioxide powder (volume-based D50 particle size: 0.7 µm) was provided. This raw material powder was mixed with a ball mill using SiC balls in ethanol for 24 hours, and the resultant mixture was dried to obtain a mixed powder. As a SiC single crystal layer, a commercially available SiC single crystal substrate (n-type 4H-SiC, diameter approximately 100 mm (4 inches), Si surface, (0001) plane, off angle 4°, thickness 0.35 mm, without an orientation flat) was provided, and the mixed powder was jetted onto the SiC single crystal substrate in the AD apparatus 50 shown in Figure 3 to form an AD film (orientation precursor layer).

Conditions for depositing the AD film were as follows. Firstly, He was used as a carrier gas, and the film was deposited using a nozzle made of a ceramic and being such that a slit of 5 mm in long side × 0.4 mm in short side was formed. The condition for scanning the nozzle was as follows. The scan speed was set to 0.5 mm/s, the following scans were repeated: moving the nozzle 105 mm in a vertical and advancing direction with respect to the long side of the slit; moving the nozzle 5 mm in the long side direction of the slit; moving the nozzle 105 mm in a vertical and returning direction with respect to the long side of the slit; and moving the nozzle 5 mm in the long side direction of the slit and the opposite direction to the initial position, at the time when the nozzle was moved 105 mm from the initial position in the long side direction of the slit, scans were conducted in directions opposite to the previous directions to return the nozzle to the initial position, and this cycle was defined as one cycle, and this cycle was repeated up to 4000 cycles. The AD film thus formed had a thickness of about 400 µm.

### (2) Heat Treatment of Orientation Precursor Layer

The SiC single crystal substrate on which the AD film, which is the orientation precursor layer was formed was taken out of the AD apparatus, and annealed in an argon atmosphere at 2400°C for 10 hours. In other words, the orientation precursor layer was subjected to heat treatment to form a heat-treated layer.

### (3) Grinding

### (3a) Surface Grinding

A (0001) plane of the SiC single crystal substrate including a heat-treated layer formed thereon was subjected to surface grinding with a grinder (diamond wheel of #1000 to 6000) to a predetermined thickness to achieve a targeted thickness and surface state.

### (3b) Bottom Surface Grinding

A (000-1) plane of the SiC single crystal substrate including a heat-treated layer formed thereon was subjected to surface grinding with a grinder (diamond wheel of #1000 to 6000) to a predetermined thickness to achieve a targeted thickness and surface state. Thus, a SiC substrate was obtained.

### (4) Occurrence of Breakings and Cracks After Processing

Using an industrial microscope (manufactured by Nikon Corporation, ECLIPSE LV150N), the magnification of the eyepiece lens was set to 10x, and the magnification of the objective lens was set to 5x. The entire surface of the SiC substrate obtained in (3) was observed in the polarizing mode and the differential interference contrast mode, and if breakings and cracks were found in the substrate, the substrate was regarded as a substrate having breakings and cracks. At this time, only breakings and cracks having a length of 100 µm or more were counted as breakings and cracks. Among 100 SiC substrates produced under the same condition as the production condition of the SiC substrate produced in the above manner, the number of SiC substrates having breakings and cracks with a length of 100 µm or more was obtained for calculation of the occurrence P_{C}(%) of breakings and cracks. This P_{C} was obtained for evaluation of the yield of the substrate. The results were as shown in Table 1.

### (5) Cutting of SiC Substrate

After the evaluation of (4), the SiC substrate without breakings or cracks was cut with a diamond cutter to be processed into a chip shape of around 5 mm × 5 mm.

### (6) Polishing

### (6a) Surface Polishing

A (0001) plane of the SiC substrate in a chip shape obtained in (5) was subjected to polishing using diamond abrasive grains, and then to a CMP (Chemical Mechanical Polishing) finish into a targeted thickness and surface state.

### (6b) Bottom Surface Polishing

A (000-1) plane of the SiC substrate in a chip shape obtained in (5) was subjected to polishing using diamond abrasive grains into a targeted thickness and surface state.

### (7) Evaluation of Biaxial Orientation Property of Heat-Treated Layer

Inverse pole figure mapping was measured using the EBSD (Electron Back Scatter Diffraction Patterns) method for the surface (plate surface) and section orthogonal to the plate surface of the heat-treated layer obtained in (3) under the following conditions to find the tilt angle distribution to be 0.01° or less for both the approximate normal direction and the approximate plate surface direction, and therefore the heat-treated layer was determined to be a biaxially oriented SiC layer oriented along the c-axis and the a-axis, and was determined to have the same off angle as that of the SiC single crystal substrate.

### <Conditions for EBSD Measurement>

· Measurement apparatus: a SEM (manufactured by Hitachi High-Technologies Corporation, SU-5000) equipped with an Electron Back Scatter Diffraction apparatus (EBSD) (manufactured by Oxford Instruments, Nordlys Nano)
· Acceleration voltage: 15 kv
· Spot intensity: 70
· Working distance: 22.5 mm
· Step size: 0.5 µm
· Tilt angle of sample: 70°
· Measurement program: Aztec (version 3.3)

### (8) X-ray Topography (XRT) Measurement of Heat-Treated Layer

The tip (around 5 mm × 5 mm) of the heat-treated layer (biaxially oriented SiC layer) produced in (1) to (6) was used as an evaluation sample, and an XRT image of the evaluation sample was obtained under the conditions shown below.

### <Conditions for XRT Measurement>

· Measurement apparatus: X-ray topography imaging system (manufactured by Rigaku Corporation, XRTmicron)
· Measurement region: 4 mm-square region
· Observation mode: 3D-XRT
· Diffraction plane: (22-40) plane
· X-ray source: Cu, Kα
· Tube voltage/tube current: 40 kV/30mA
· Detector: CCD camera

The 3D-XRT data were superimposed to obtain an XRT image shown in Figure 4. Among linear contrasts observed in this XRT image, linear contrasts such that the XRT intensity was within the top 5% (the arrows a and b in Figure 4) were regarded as BPDs, and the total number of the BPDs was counted. Using the counted total number, the BPD density C_{BPD, XRT} (/cm²) in the 4 mm-square region was calculated. Then, with respect to the total number of the BPDs, the percentage P_{BPD}, _{XRT} (%) of the number of the BPDs such that the absolute value of an acute angle between the BPD extension direction and the [11-20] direction was 15° or less (the arrow a in Figure 4) was calculated. The arrow b in Figure 4 shows a BPD such that the absolute value of an acute angle is more than 15°. The BPD extension direction is defined as a direction of a line segment connecting the end point of a BPD observed as a linear shape and a point 150 µm away from the end point along the linear BPD in the XRT image. The results were as shown in Table 1.

### (9) Optical Microscope Observation of Heat-Treated Layer

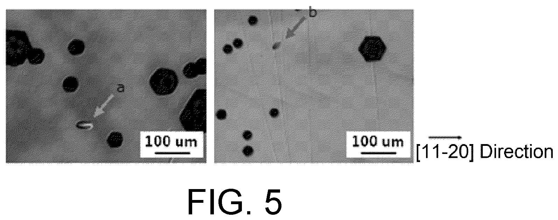

The tip (around 5 mm × 5 mm) of the heat-treated layer (biaxially oriented SiC layer) produced in (1) to (6) was used as an evaluation sample. The evaluation sample was placed together with a KOH crystal in a crucible made of nickel and was subjected to etching treatment in an electric furnace at 500°C for 10 minutes. The evaluation sample after the etching treatment was rinsed, and a plane inclined by an off angle from a (0001) plane of a 4 mm-square region in the heat-treated layer (biaxially oriented SiC layer) that was the evaluation sample was observed with an optical microscope of the magnification of 50x. The total number of the BPDs identified as oval etch pits in this optical microscope image was counted, and the BPD density C_{BPD, KOH} (/cm²) in the 4 mm-square region was calculated. Then, with respect to the total number of the BPDs, the percentage P_{BPD, KOH} (%) of the number of the BPDs such that the absolute value of an acute angle between the BPD extension direction and the [11-20] direction was 15° or less was calculated. The results were as shown in Table 1. The BPD extension direction is defined as the long axis direction of the oval etch pit identified in the optical microscope image. An example of the observed BPD is shown in Figure 5. The arrow a in Figure 5 shows a BPD such that the absolute value of an acute angle between the BPD extension direction and the [11-20] direction is 15° or less, and the arrow b in Figure 5 shows a BPD such that the absolute value of an acute angle is more than 15°.

(10) Concentrations of B, N, Y, and Ce in Heat-Treated Layer (Biaxially Oriented SiC Layer) The tip (around 5 mm × 5 mm) of the heat-treated layer (biaxially oriented SiC layer) produced in (1) to (6) was used as an evaluation sample. A (0001) plane that was the polished surface of the evaluation sample was subjected to dynamic secondary ion mass spectrometry (D-SIMS). IMS-7f manufactured by CAMECA SAS was used as the apparatus for analysis of the rare earth element (Y and Ce in the present example) and B, and measurement was performed with a primary ion species of O₂⁺ and at an acceleration voltage of 11.0 kV. IMS-7f manufactured by CAMECA SAS was used as the apparatus for analysis of N, and measurement was performed with a primary ion species of Cs⁺ and at an acceleration voltage of 15.0 kV. Thus, the Y concentration C_{Y} (atoms/cm³), the Ce concentration C_{Ce} (atoms/cm³), the B concentration C_{B} (atoms/cm³), and the N concentration C_{N} (atoms/cm³) were measured. The results were as shown in Table 1.

### Example 2

A SiC substrate was produced and evaluated as in Example 1 except that a raw material powder containing 82.7% by weight of the β-SiC fine powder (volume-based D50 particle size: 0.7 µm), 16.2% by weight of the yttrium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 3 (Comparison)

A SiC substrate was produced and evaluated as in Example 1 except that a raw material powder containing 74.9% by weight of the β-SiC fine powder (volume-based D50 particle size: 0.7 µm), 24.0% by weight of the yttrium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 4

A SiC substrate was produced and evaluated as in Example 1 except that a raw material powder containing 94.9% by weight of the β-SiC fine powder (volume-based D50 particle size: 0.7 µm), 4.0% by weight of the yttrium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 5 (Comparison)

A SiC substrate was produced and evaluated as in Example 1 except that a raw material powder containing 97.9% by weight of the β-SiC fine powder (volume-based D50 particle size: 0.7 µm), 1.0% by weight of the yttrium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 6

A SiC substrate was produced and evaluated as in Example 1 except that a raw material powder containing 90.8% by weight of the β-SiC fine powder (volume-based D50 particle size: 0.7 µm), 8.1% by weight of the cerium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 7

A SiC substrate was produced and evaluated as in Example 1 except that a raw material powder containing 82.7% by weight of the β-SiC fine powder (volume-based D50 particle size: 0.7 µm), 16.2% by weight of the cerium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 8 (Comparison)

A SiC substrate was produced and evaluated as in Example 1 except that a raw material powder containing 74.9% by weight of the β-SiC fine powder (volume-based D50 particle size: 0.7 µm), 24.0% by weight of the cerium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 9

A SiC substrate was produced and evaluated as in Example 1 except that a raw material powder containing 94.9% by weight of the β-SiC fine powder (volume-based D50 particle size: 0.7 µm), 4.0% by weight of the cerium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 10 (Comparison)

A SiC substrate was produced and evaluated as in Example 1 except that a raw material powder containing 97.9% by weight of the β-SiC fine powder (volume-based D50 particle size: 0.7 µm), 1.0% by weight of the cerium oxide powder (volume-based D50 particle size: 0.1 µm), and 1.1% by weight of the silicon dioxide powder (volume-based D50 particle size: 0.7 µm) was used in (1). The resultant heat-treated layer was confirmed to be a biaxially oriented SiC layer. The results were as shown in Table 1.

### Example 11

A SiC substrate was produced and evaluated as in Example 1 except that a raw material powder containing 88.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 2.0% by weight of the boron carbide powder (volume-based D50 particle size: 0.5 µm) was used in (1). The resultant heat-treated layer was confirmed to be a biaxially oriented SiC layer. The results were as shown in Table 1.

### Example 12

A SiC substrate was produced and evaluated as in Example 1 except that a raw material powder containing 86.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 4.0% by weight of the boron carbide powder (volume-based D50 particle size: 0.5 µm) was used in (1). The resultant heat-treated layer was confirmed to be a biaxially oriented SiC layer. The results were as shown in Table 1.

### Example 13

A SiC substrate was produced and evaluated as in Example 1 except that a raw material powder containing 82.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 8.0% by weight of the boron carbide powder (volume-based D50 particle size: 0.5 µm) was used in (1). The resultant heat-treated layer was confirmed to be a biaxially oriented SiC layer. The results were as shown in Table 1.

### Example 14

A SiC substrate was produced and evaluated as in Example 1 except that a raw material powder containing 74.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 16.0% by weight of the boron carbide powder (volume-based D50 particle size: 0.5 µm) was used in (1). The resultant heat-treated layer was confirmed to be a biaxially oriented SiC layer. The results were as shown in Table 1.

### Example 15 (Comparison)

A SiC substrate was produced and evaluated as in Example 1 except that a raw material powder containing 58.8% by weight of the β-SiC fine powder (volume-based D50 particle size: 0.7 µm), 8.1% by weight of the yttrium oxide powder (volume-based D50 particle size: 0.1 µm), 1.1% by weight of the silicon dioxide powder (volume-based D50 particle size: 0.7 µm), and 32% by weight of the boron carbide powder (volume-based D50 particle size: 0.5 µm) was used in (1). The resultant heat-treated layer was confirmed to be a biaxially oriented SiC layer. The results were as shown in Table 1.

### Example 16

A SiC substrate was produced and evaluated as in Example 1 except that the heat treatment atmosphere was set to 99.95% of argon and 0.05% of nitrogen in (2). The resultant heat-treated layer was confirmed to be a biaxially oriented SiC layer. The results were as shown in Table 1.

### Example 17

A SiC substrate was produced and evaluated as in Example 1 except that the heat treatment atmosphere was set to 99.9% of argon and 0.1% of nitrogen in (2). The resultant heat-treated layer was confirmed to be a biaxially oriented SiC layer. The results were as shown in Table 1.

### Example 18

A SiC substrate was produced and evaluated as in Example 1 except that the heat treatment atmosphere was set to 99.5% of argon and 0.5% of nitrogen in (2). The resultant heat-treated layer was confirmed to be a biaxially oriented SiC layer. The results were as shown in Table 1.

### Example 19

A SiC substrate was produced and evaluated as in Example 1 except that the heat treatment atmosphere was set to 99.0% of argon and 1.0% of nitrogen in (2). The resultant heat-treated layer was confirmed to be a biaxially oriented SiC layer. The results were as shown in Table 1.

### Example 20 (Comparison)

A SiC substrate was produced and evaluated as in Example 1 except that the heat treatment atmosphere was set to 70.0% of argon and 30.0% of nitrogen in (2). The resultant heat-treated layer was confirmed to be a biaxially oriented SiC layer. The results were as shown in Table 1.

### [Table 1]

**Table 1**

| | BPD in XRT image | | BPD in optical microscope image | | Concentration of each element | | | | Occurrence of breakings and cracks (%) |
|---|---|---|---|---|---|---|---|---|---|
| | C_{BPD,XRT} (/cm²) | P_{BPD,XRT} (%) | C_{BPD,KOH} (/cm²) | P_{BPD,KOH} (%) | C_{Y} (×10¹⁵ atoms/ cm³) | C_{Ce} (×10¹⁵ atoms/ cm³) | C_{B} (×10¹⁶ atoms/ cm³) | C_{N} (×10¹⁸ atoms/ cm³) | P_{C} |
| Ex. 1 | 50 | 63 | 36 | 78 | 2.0 | 0 | 0.16 | 1.5 | 2 |
| Ex. 2 | 44 | 86 | 32 | 75 | 3.9 | 0 | 0.21 | 1.5 | 6 |
| Ex. 3* | 56 | 44 | 44 | 36 | 6.0 | 0 | 0.20 | 1.6 | 62 |
| Ex. 4 | 31 | 60 | 28 | 100 | 0.75 | 0 | 0.18 | 1.4 | 2 |
| Ex. 5* | 50 | 25 | 32 | 38 | 0.094 | 0 | 0.19 | 1.5 | 51 |
| Ex. 6 | 38 | 67 | 20 | 80 | 0 | 2.4 | 0.17 | 1.3 | 4 |
| Ex. 7 | 56 | 78 | 36 | 89 | 0 | 4.4 | 0.20 | 1.5 | 5 |
| Ex. 8* | 56 | 33 | 40 | 40 | 0 | 6.3 | 0.19 | 1.5 | 67 |
| Ex. 9 | 50 | 63 | 32 | 88 | 0 | 0.70 | 0.21 | 1.7 | 3 |
| Ex. 10* | 63 | 30 | 48 | 33 | 0 | 0.080 | 0.19 | 1.4 | 46 |
| Ex. 11 | 31 | 80 | 24 | 83 | 1.4 | 0 | 6.0 | 1.5 | 3 |
| Ex. 12 | 13 | 100 | 8 | 100 | 1.6 | 0 | 15 | 1.6 | 8 |
| Ex. 13 | 25 | 75 | 16 | 75 | 2.1 | 0 | 37 | 1.4 | 8 |
| Ex. 14 | 50 | 63 | 24 | 83 | 1.5 | 0 | 82 | 1.5 | 12 |
| Ex. 15* | 50 | 13 | 32 | 25 | 1.5 | 0 | 150 | 1.5 | 66 |
| Ex. 16 | 25 | 75 | 16 | 75 | 2.6 | 0 | 0.20 | 5.0 | 4 |
| Ex. 17 | 31 | 100 | 24 | 100 | 2.3 | 0 | 0.19 | 6.2 | 9 |
| Ex. 18 | 44 | 86 | 28 | 86 | 1.9 | 0 | 0.20 | 9.4 | 11 |
| Ex. 19 | 50 | 63 | 36 | 78 | 2.0 | 0 | 0.18 | 12 | 12 |
| Ex. 20* | 263 | 24 | 284 | 21 | 2.1 | 0 | 0.20 | 52 | 84 |

| | | | | | | | | | |
|---|---|---|---|---|---|---|---|---|---|
| * indicates a comparative example. | | | | | | | | | |

It was found that the BPD extension direction and the BPD density can be controlled by the type of carrier gas and Y, Ce, N, and B concentrations in the biaxially oriented SiC layer, although the cause is not certain. In addition, it was found that occurrence of breakings and cracks during processing can be controlled by the percentage of the number of BPDs such that the absolute value of an acute angle between the BPD extension direction and the [11-20] direction is 15° or less. In particular, it was found that the breakings and cracks during processing can be reduced more effectively where a rare earth element concentration is 5.0 × 10¹⁴ to 5.0 × 10¹⁵ atoms/cm³, where a N concentration is 1.0 × 10¹⁸ to 2.0 × 10¹⁹ atoms/cm³, and where a B concentration is 2.0 × 10¹⁵ to 1.0 × 10¹⁷ atoms/cm³.

## Claims

1. A SiC substrate comprising a biaxially oriented SiC layer, wherein the SiC substrate and the biaxially oriented SiC layer have an off angle,
wherein, in an XRT image obtained by subjecting a certain 4 mm-square region in the biaxially oriented SiC layer to an X-ray topography (XRT) measurement, with respect to a total number of basal plane dislocations (BPD), a percentage of the number of the BPDs such that an absolute value of an acute angle between a BPD extension direction and the [11-20] direction is 15° or less is 60% or more, and
wherein the BPD extension direction is defined as a direction of a line segment connecting an end point of the BPD observed as a linear shape and a point 150 µm away from the end point along the linear BPD in the XRT image.

2. A SiC substrate comprising a biaxially oriented SiC layer, wherein the SiC substrate and the biaxially oriented SiC layer have an off angle,
wherein, in an optical microscope image obtained by observing a plane inclined by the off angle from a (0001) plane after a KOH etching in a certain 4 mm-square region in the biaxially oriented SiC layer, with respect to a total number of basal plane dislocations (BPD), a percentage of the number of the BPDs such that an absolute value of an acute angle between a BPD extension direction and the [11-20] direction is 15° or less is 70% or more, and
wherein the BPD extension direction is defined as the long axis direction of an oval etch pit identified in the optical microscope image.

3. The SiC substrate according to claim 1 or 2, wherein a rare earth element concentration of the biaxially oriented SiC layer is 1.0 × 10¹⁴ to 5.0 × 10¹⁵ atoms/cm³.

4. The SiC substrate according to claim 1 or 2, wherein a N concentration of the biaxially oriented SiC layer is 1.0 × 10¹⁸ to 5.0 × 10¹⁹ atoms/cm³.

5. The SiC substrate according to claim 1 or 2, wherein a B concentration of the biaxially oriented SiC layer is 1.0 × 10¹⁵ to 1.0 × 10¹⁸ atoms/cm³.

6. The SiC substrate according to claim 1 or 2, wherein, in the optical microscope image obtained by observing the plane inclined by the off angle from the (0001) plane after the KOH etching in the biaxially oriented SiC layer, the SiC substrate includes a 5 mm-square region in which a density of the oval etch pit that is the BPD is 50/cm² or less.

7. A SiC composite substrate comprising:
a SiC single crystal substrate; and
the SiC substrate according to claim 1 or 2 on the SiC single crystal substrate.
